# EUROPEAN PATENT APPLICATION

(11) **EP 0 716 565 A1**
(43) Date of publication of application: **12.06.1996**
(21) Application number: 95308709.5
(22) Date of filing: 01.12.1995
(51) Int. Cl.: H05K 5/02, G06F 1/16, H01R 23/02, H01R 13/639

(54) **IC Card**

(30) Priority: 09.12.1994 JP 306514/94
(71) Applicant: International Business Machines Corporation, Armonk, N.Y. 10504 (US)
(72) Inventor: Chiba, Kazuo, Kawasaki-shi, Kanagawa-ken (JP); Ozawa, Masakatsu, Ebina-shi, Kanagawa-ken (JP); Imamura, Kenichi, Yokohama-shi, Kanagawa-ken (JP)
(74) Representative: Davies, Simon Robert

(57) **Abstract**

Disclosed is a connector, which is provided in a IC card body, wherein a socket or a jack is inserted in a direction that is parallel to the face of an IC card. According to the present invention, provided on an IC card body 302 is a flat plate member 305 incorporating a rotatable housing 306, which has an opening 312 by which a socket or a jack can be fitted, that is attached to the flat plate member 305. With this structure, when a socket or a jack is not connected to the IC card, the flat plate member 305 lies level along the face of the IC card; but when a socket is to be connected, the housing 306 of the flat plate member is raised so as to be almost perpendicular to the face of the IC card. The socket or the jack can therefore be inserted parallel to the face of the IC card, and even when an adjacent IC card is loaded, interference with that IC card is minimal.

## Description

The present invention relates to an IC card, such as a PCMCIA card, and in particular to the structure of its connector.

Conventional personal computers have a plurality of ICs or LSIs mounted in it for connection to external devices, such as magneto-optical disk drives, CD-ROM drives, or token ring networks, and also includes a printed circuit board with a dedicated connector that is attached to the body of a computer.

A printed circuit board on which a discrete IC or LSI is mounted can no longer be attached to an A4-sized notebook or an A5-sized sub-notebook portable computer, such as ThinkPad (IBM trademark), which is available from IBM Corp. because the size of the computer case is limited.

The PCMCIA (Personal Computer Memory Card International Association), for the standardization of personal computer IC cards, was established in the United States in 1989, and determined the standards for personal computer IC cards. Therefore, an IC card that conforms to the standards is called a PCMCIA card.

Since the size of a PCMCIA card is standardized, and since various integrated circuits are packaged on a card that is almost the equivalent in size of a business card, many recent portable computers include a slot for such a PCMCIA card.

But even such PCMCIA cards have a shortcoming. It is difficult to attach a connector for an external device to a PCMCIA card because the card is extremely thin, about 3 to 10 mm.

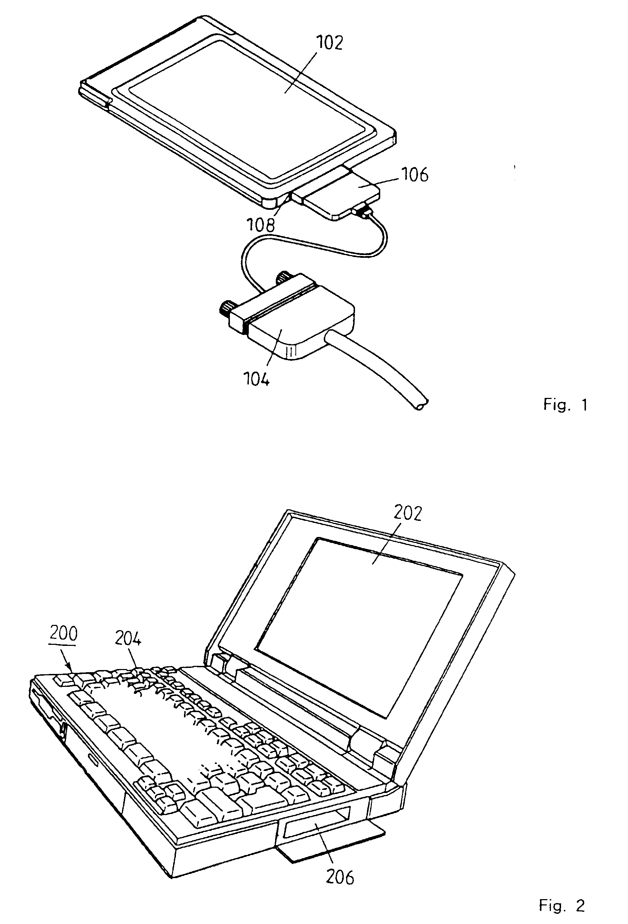

One technique that is proposed to resolve this shortcoming is, as is shown in Fig. 1, the use of an intermediate conversion cable 106 to connect a PCMCIA card 102 to an external socket 104. A disadvantage of this structure, however, is that an attachment portion 108 of the PCMCIA card 102 can be easily damaged when the conversion cable 106 is pulled.

In Japanese Unexamined Patent Publication No. Hei 6-61660 is disclosed the structure of a modular jack connector that is composed of a flat plate member, which extends from one end to the other and parallel to the face of an IC card, wherein is formed at one end a hole having a cover which can be freely opened and closed that, when open, permits the insertion of a modular jack so that the jack is positioned perpendicular to the face of the IC card.

With the structure of the IC card connector that is disclosed in Japanese Unexamined Patent Publication No. Hei 6-61660, since a modular jack must be so inserted that it is perpendicular to the face of the IC card, when another PCMCIA card is inserted adjacent to that card, it is possible that the modular jack will abut upon the newly inserted PCMCIA card, thereby making it difficult to insert the modular jack or preventing the PCMCIA card from being coupled with a connector.

Accordingly, the present invention provides an IC card comprising: (a) a substantially flat IC card body; (b) a connector body that extends from one end of said IC card body so as to be substantially parallel to a flat face of said IC card body, said connector body being formed of an electric insulation material; (c) a rotary member, formed of an electrical insulation material, supported by said connector body so as to be rotatable to a first position which is parallel to said flat face of said IC card body, and to a second position which is perpendicular to said flat face of said IC card, said member having an opening whereby a jack can be accepted at said second position in a direction that is parallel to said flat face of said IC card body; and (d) multiple terminals which are provided in said connector body for forming electric contact with corresponding terminals of said jack when said jack is releasably retained in said rotary member.

Advantageously, an embodiment provides for an IC card a structure, for a connector that is a part of the IC card, wherein a socket or a jack can be inserted so that it is positioned parallel to the face of an IC card.

A flat plate member is provided, as a part of an IC card, to which a rotatable housing is so attached that when the IC card is disconnected from a socket the flat plate member and the rotatable housing are level with the face of the IC card, and when a socket or a jack is to be connected, the rotatable housing can be shifted so that it is almost perpendicular to the face of the IC card. Further, an opening into which the socket or the jack can be fitted is provided within the housing.

With the above structure, a socket or a jack can be so inserted that it is positioned parallel to the face of the IC card, and even when an IC card is located adjacent to it, interference with that IC card will be minimal.

In addition, according to a preferred embodiment, the portion of the flat plate member that can be positioned upright can be rotated to either side of the flat plate member, so that the portion can be shifted to the side where it is most convenient for the employment by a user.

An embodiment of the present invention will now be described, by way of example only, with reference to the accompanying drawings in which:

Fig. 1 is a diagram illustrating the state where a conversion connector for a PCMCIA card is used.

Fig. 2 is a perspective view of the outline of a portable computer that has a slot for a PCMCIA card.

Fig. 3 is a perspective view of the outline of a PCMCIA card.

Fig. 4 is a diagram showing the state when a PCMCIA card has been inserted into the slot of a portable computer.

Fig. 5 is a diagram showing the state when a connector structure for the PCMCIA card has been pulled out.

Fig. 6 is a diagram showing the state when the connector housing of a PCMCIA card has been raised until it is almost perpendicular.

Fig. 7 is a diagram showing the state when a modular jack has been inserted into the connector housing of a PCMCIA card.

Fig. 8 is a diagram showing the state when a modular jack has been inserted into the connector housing of a PCMCIA card.

Fig. 9 is a diagram showing the state when the connector housing of a PCMCIA card has been rotated downward until it is almost perpendicular.

Referring to Fig. 2, there is shown a perspective view of the outline of a portable computer 200. In the portable computer 200 are included a color liquid crystal panel screen 202 and a keyboard 204. A slot 206 into which a PCMCIA card can be inserted is provided in the right side of the computer 200.

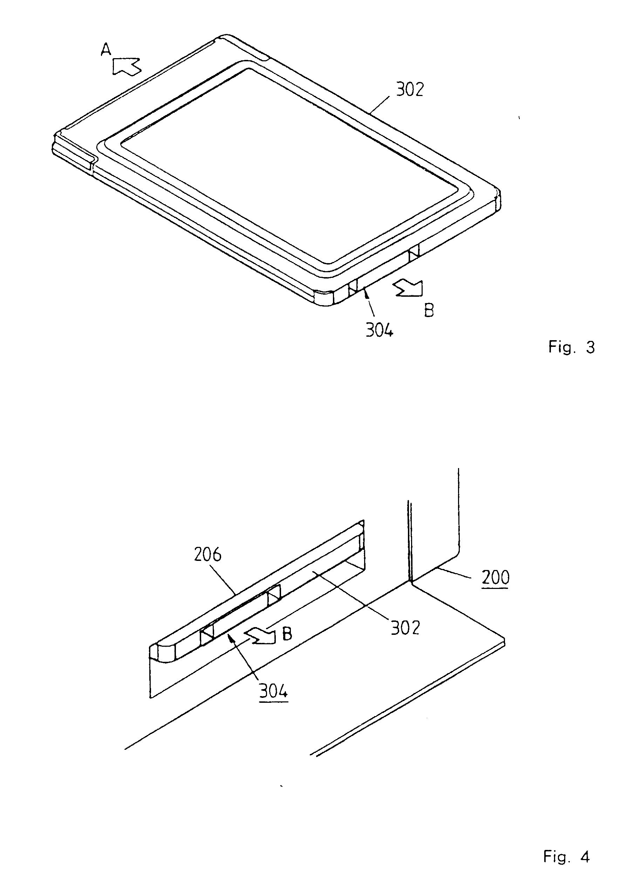

In Fig. 3 is shown a PCMCIA card 302 that has a connector structure 304 according to the embodiment. In this embodiment, the connector structure 304 is employed to connect a modular jack for a telephone, and a PCMCIA card 302 functions as, for example, a modem for the portable computer 200. The PCMCIA card 302 can be inserted into the slot 206 in the direction indicated by the arrow A. In the initial state, as is shown in Figs. 3 and 4, the connector structure 304 has been inserted into the body of the PCMCIA card 302.

The connector structure 304 is loaded using a push-pop mechanism. By pressing inward in the direction that is the opposite of that indicated by the arrow B in Fig. 4, the connector structure 304 is projected outward from the PCMCIA card 302 in the direction that is indicated by the arrow B in Fig. 4.

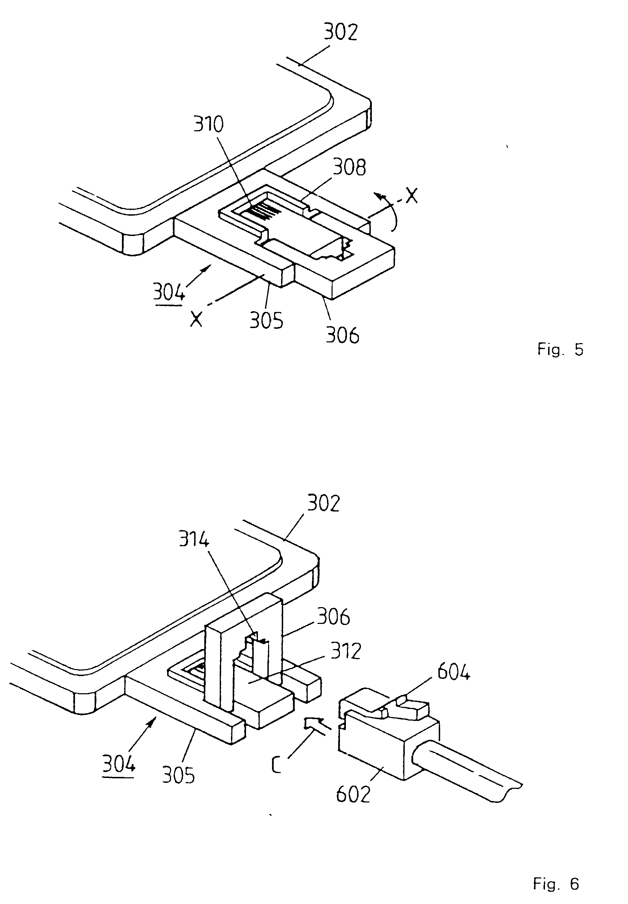

The state shown in Fig. 5 is when the connector structure 304 has been projected outward in the above described manner. The connector structure 304 roughly comprises a connector body 305, which can be shifted parallel to the face of the card 302, and an inverted U-shaped housing 306, which is supported at the connector body 305 so as to be rotatable around an imaginary axis indicated by X-X. The connector 305 and the housing 306 are both made of insulating plastic. The connector 305 further includes a convex rib 308, which abuts upon the front face of an inserted modular jack to guide and to secure it, and a plurality of conductive terminals 310, which are contacted by and electrically connected to the terminals of the modular jack when the modular jack is inserted and is in contact with the rib 308.

In Fig. 6, the housing 306 has been rotated upward and around the axis X until it is substantially perpendicular to the face of the PCMCIA card 302. Since the housing 306 is so formed that it has an almost inverted U shape, the housing 306 forms an opening 312 while it is upright.

A recessed portion 314 is formed in the upper end of the opening 312 to engage a latch 604 of a modular jack 602.

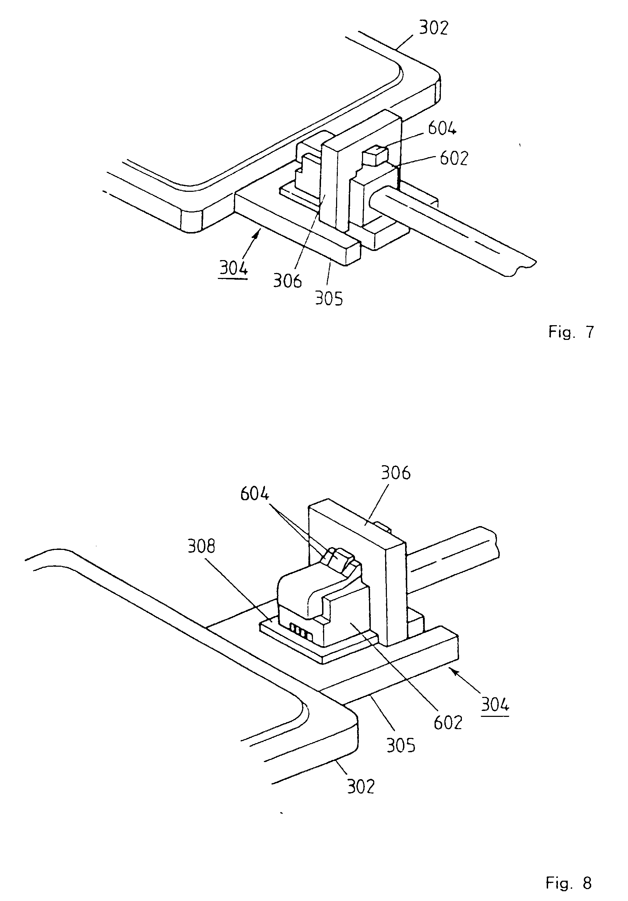

When, in Fig. 6, the modular jack 602 is moved in the direction that is indicated by the arrow C and is inserted into the opening 312 of the housing 306, as is shown in Fig. 7, the front end of the modular jack 602 abuts upon the rib 308 and the latch 604 engages the recessed portion 314, so that the modular jack 602 is releasably retained in the connector structure 304.

Fig. 8 is a further view from a different direction, of the modular jack 602 when fitted into the connector structure 304.

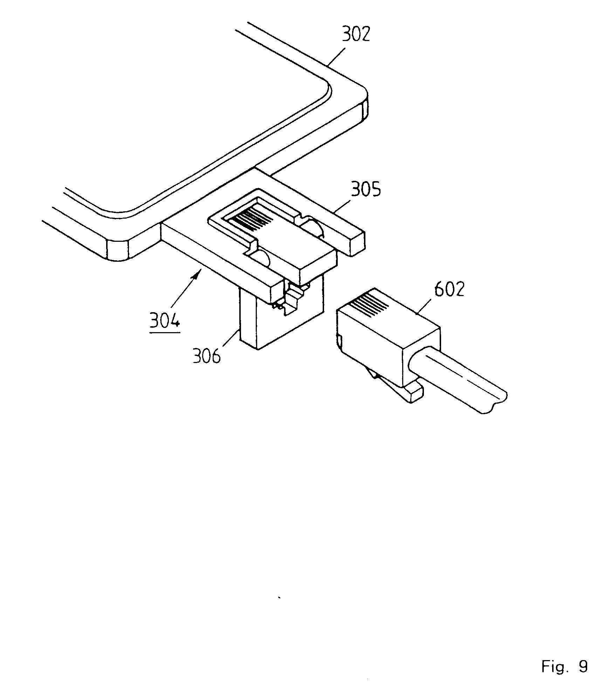

Although not shown, according to the preferred embodiment of the present invention, a rib 308 and terminals 310 are formed on the reverse of the connector structure 304 in the same manner as is shown in Fig. 5, and the housing 306 can be rotated downward until it is almost perpendicular to the face of the PCMCIA card 302, as is shown in Fig. 9. In Fig. 9, the modular jack 602 is upside down when it is inserted into the connector structure 304.

To remove the modular jack 602, it need only be pulled in the direction that is the opposite of that indicated by the arrow C in Fig. 6 while the latch 604 is depressed.

The housing 306 is rotated downward to the original position in Fig. 5, and the connector structure 304 is pushed inside the card 302, as is shown in Fig. 4. Then, the connector structure 304 is held within the body of the card 302 by the aforementioned push-pop mechanism, as is shown in Fig. 4. In this manner, it is possible to prevent the connector structure 304 from being damaged by its striking a desk or a chair while the portable computer 200 is being carried.

As described above, according to the embodiment, a rotatable housing is provided as an IC card connector that can be raised until it is almost perpendicular to the face of the IC card, and an opening is formed in the housing into which a socket (a jack) can be fitted. Thus, the socket can be inserted in a direction that is parallel to the face of the IC card, and even when there is an adjacently located IC card, interference with that card will be minimal.

According to a preferred embodiment of the present invention, the housing can be rotated to either side, and a user can therefore rotate the housing to the side that is the most convenient to use.

Although in this embodiment a modular jack has been employed as an example device that is fitted into the connector structure, the structure for the connector of the present invention can be applied to any socket, jack, or plug that is intended to be fitted into an opening.

## Claims

1. An IC card (302) comprising:
(a) an substantially flat IC card body;
(b) a connector body (305) that extends from one end of said IC card body so as to be substantially parallel to a flat face of said IC card body, said connector body (305) being formed of an electric insulation material;
(c) a rotary member (306), formed of an electrical insulation material, supported by said connector body (305) so as to be rotatable to a first position which is parallel to said flat face of said IC card body, and to a second position which is perpendicular to said flat face of said IC card, said member having an opening whereby a jack can be accepted at said second position in a direction that is parallel to said flat face of said IC card body; and
(d) multiple terminals (310) which are provided in said connector body for forming electric contact with corresponding terminals of said jack when said jack is releasably retained in said rotary member.

2. An IC card according to claim 1, wherein said rotary member (306) is so formed as to have a substantially inverted U shape.

3. An IC card according to either of claims 1 or 2, wherein said connector body (305) is arranged so as to be capable of being loaded into and unloaded from said IC card body.

4. An IC card according to any preceding claim, wherein said jack is a modular jack (602) for a telephone.

5. An IC card according to claim 4, wherein a (308) rib is provided on said connector body (305) so as to abut upon said modular jack (602) while said modular jack is inserted.

6. An IC card according to either of claims 4 or 5, wherein a recessed portion (314) is formed in said opening of said rotary member (306) to engage a latch (604) of said modular jack (602).

7. An IC card according to any preceding claim, wherein said rotary member is rotatable to a third position, which, with said first position serving as a referential position, is at a side opposite to a side to which said rotary member is rotated for said second position, whereat said rotary member is positioned perpendicular to said flat face of said IC card body.
